# FASCICULE DE BREVET EUROPEEN

(11) **EP 3 234 540 B1**
(45) Date de publication et mention de la délivrance du brevet: **26.09.2018**
(21) Numéro de dépôt: 15808594.4
(22) Date de dépôt: 11.12.2015
(51) Int. Cl.: G01R 33/12, G01N 27/72, G01M 17/02, G01B 7/06

(54) **PROCÉDÉ DE MESURE DE L'ÉPAISSEUR D'UNE COUCHE DE MATÉRIAU CAOUTCHOUTEUX**
SYSTEM ZUR MESSUNG DER DICKE EINER SCHICHT AUS KAUTSCHUKARTIGEM MATERIAL
METHOD FOR MEASURING THE THICKNESS OF A LAYER OF RUBBER-LIKE MATERIAL

(30) Priorité: 17.12.2014 FR 1462589
(43) Date de publication de la demande: 25.10.2017
(73) Titulaire: Compagnie Générale des Etablissements Michelin, 63000 Clermont-Ferrand (FR)
(72) Inventeur: LEDOUX, Thomas, 63040 Clermont-Ferrand Cedex 9 (FR); MARTIN, Denis, 63040 Clermont-Ferrand Cedex 9 (FR); PERNOT, Alexandre, 63040 Clermont-Ferrand Cedex 9 (FR); HEREDIA, Guillaume, 63040 Clermont-Ferrand Cedex 9 (FR); MENEROUD, Patrick, 38246 Meylan Cedex (FR); GOEAU, Cédric, 38246 Meylan Cedex (FR)
(74) Mandataire: Roussy, Delphine
(86) Numéro de dépôt international: PCT/EP2015/079454
(87) Numéro de publication internationale: WO 2016/096661

(56) Documents cités:
- EP-A1- 0 100 009
- EP-A1- 2 009 389
- EP-A2- 2 706 351
- DE-C1- 3 507 651
- DE-U1- 9 013 605
- US-A- 3 675 375
- US-A1- 2014 125 330

## Description

### DOMAINE DE L'INVENTION

L'invention se situe dans le domaine des pneumatiques pour véhicules, et plus précisément dans le domaine de l'évaluation de l'usure de tels pneumatiques.

De manière connue, la bande de roulement d'un bandage pneumatique ou plus simplement pneumatique, qu'il soit destiné à équiper un véhicule de tourisme, poids lourd, Génie Civil ou autre..., est pourvue d'une sculpture comprenant notamment des éléments de sculpture ou blocs élémentaires délimités par diverses rainures principales, longitudinales, transversales ou encore obliques, les blocs élémentaires pouvant en outre comporter diverses incisions ou lamelles plus fines. Les rainures constituent des canaux destinés à évacuer l'eau lors d'un roulage sur sol mouillé et définissent les bords d'attaque des éléments de sculpture.

Quand un pneumatique est neuf, la bande de roulement présente une hauteur initiale maximale. Cette hauteur initiale peut varier en fonction du type de pneumatique considéré ainsi que de l'usage auquel il est destiné ; à titre d'exemple, les pneumatiques « hiver » ont généralement une profondeur de sculpture supérieure à celle de pneumatiques « été ». Lorsque le pneumatique s'use, la hauteur des blocs élémentaires de la sculpture diminue et la raideur de ces blocs élémentaires augmente. L'augmentation de raideur des blocs élémentaires de sculpture entraîne une diminution de certaines performances du pneumatique, telle l'adhérence sur sol mouillé. De plus, les capacités d'évacuation d'eau diminuent fortement lorsque la profondeur des canaux des sculptures diminue.

Il est donc souhaitable de pouvoir suivre l'évolution de l'usure de la bande de roulement d'un pneumatique. Un tel suivi est usuellement réalisé par observation visuelle de la bande de roulement par l'usager ou un garagiste avec ou sans une mesure effective avec une jauge de profondeur. Mais cette observation n'est pas très aisée à réaliser notamment sur les pneumatiques arrière d'accès plus difficile et n'est pas non plus très précise.

De nombreuses propositions ont été faites pour automatiser la mesure de la profondeur de sculptures de pneumatiques. De tels dispositifs peuvent être disposés sur le sol de roulage des véhicules.

On connaît ainsi des dispositifs de mesure à base de systèmes optiques, comprenant par exemple des caméras ou des lasers. Toutefois, ces systèmes sont relativement coûteux, et se révèlent peu pratiques d'utilisation, puisqu'ils doivent être encastrés dans le sol de roulage et qu'ils nécessitent une maintenance régulière. En outre, ils offrent une fiabilité de mesure contestable, puisque les mesures peuvent être fortement perturbées par des salissures et la présence ou des projections d'eau, de boue, de neige, etc.

On connaît également, notamment des documents US 7,578,180 B2 et WO 2008/059283, des systèmes de mesure de l'épaisseur de la bande de roulement d'un pneumatique, comportant des capteurs sensibles aux courants de Foucault générés par un champ magnétique d'excitation dans l'armature de sommet du pneumatique. Ces systèmes sont disposés sur un sol de roulage.

EP 2 706 351 A2 décrit un procédé de mesure de l'épaisseur d'une couche de matériau diamagnétique, et donc aussi de matériau caoutchouteux, cette couche de matériau comportant une face libre en contact avec l'air et une face liée à une armature adjacente contenant au moins un matériau hystérétique de perméabilité magnétique supérieure à la perméabilité magnétique de l'air, le procédé comportant les étapes suivantes: une étape au cours de laquelle on approche de la couche de matériau dont on souhaite mesurer l'épaisseur un élément sensible émettant un champ magnétique alternatif, une étape au cours de laquelle on mesure des pertes hystérétiques dans l'armature adjacente, mesurées aux bornes de l'élément sensible, et une étape au cours de laquelle on évalue l'épaisseur de la couche de matériau en fonction de ces pertes hystérétiques.

DE 35 07 651 décrit un procédé de mesure de l'épaisseur d'une couche de matériau caoutchouteux, cette couche de matériau comportant une face libre en contact avec l'air et une face avec une pluralité de magnets permanents, éléments ferromagnétiques et donc hystérétiques, isolés électriquement les uns des autres: un élément sensible se déplace sur la face libre de la couche et mesure le champ magnétique des magnets permanents qui donne une indication de l'épaisseur de la couche.

On a toutefois constaté que ces procédés fournissaient, sur certains types de pneumatiques, des mesures fausses ou imprécises. La présente invention vise donc à remédier à cet inconvénient en fournissant un nouveau procédé de mesure de l'épaisseur de la bande de roulement.

### BREVE DESCRIPTION DE L'INVENTION

L'invention concerne un procédé de mesure de l'épaisseur d'une couche de matériau caoutchouteux, cette couche de matériau comportant une face libre en contact avec l'air et une face liée à une armature adjacente constituée d'éléments isolés électriquement les uns des autres et contenant chacun au moins un matériau hystérétique de perméabilité magnétique supérieure à la perméabilité magnétique de l'air. Les éléments isolés électriquement les uns des autres sont, de manière préférentielle, des câbles.

Ce procédé comprend les étapes suivantes :
- Une étape au cours de laquelle on approche de la couche de matériau dont on souhaite mesurer l'épaisseur un élément sensible émettant un champ magnétique alternatif,
- Une étape au cours de laquelle on mesure des pertes hystérétiques dans l'armature adjacente, mesurées aux bornes de l'élément sensible, et
- Une étape au cours de laquelle on évalue l'épaisseur de la couche de matériau en fonction de ces pertes hystérétiques.

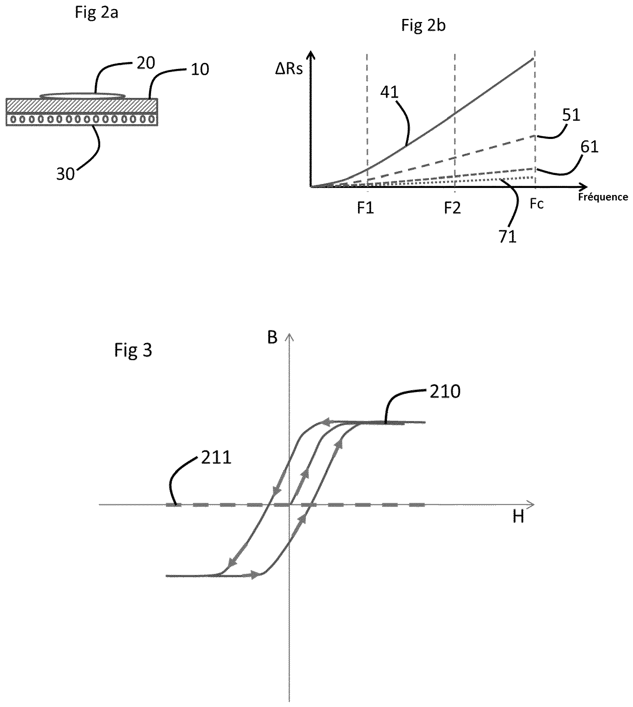

Les conditions d'application d'un procédé selon l'invention vont être détaillées à l'aide de la figure 3 qui montre les caractéristiques magnétiques de deux matériaux différents. De manière préférentielle, les éléments hystérétiques sont tous situés à la même distance de la face de la couche liée à l'armature.

De manière préférentielle encore, les éléments hystérétiques sont de dimension telle qu'elles empêchent l'apparition de courants de Foucault dans l'armature.

La courbe 210, en trait continu, est caractéristique de l'assemblage de matériaux constitutifs d'une armature de pneumatique. Partant d'une excitation magnétique H nulle, lorsque ladite excitation magnétique augmente, le champ magnétique B au coeur de l'armature de pneumatique augmente également. Dans un second temps, lorsque l'excitation magnétique H diminue, le champ magnétique B diminue également mais ne revient pas naturellement à une valeur nulle lorsque l'excitation H est nulle.

Ce phénomène, caractéristique des matériaux ferromagnétiques, prend le nom d'hystérèse et signifie que l'état magnétique du matériau dépend des états précédents. Alternativement, on dit que la courbe 210 est un cycle d'hystérèse obtenu en régime d'excitation périodique, ce qui signifie que l'excitation H est obtenue par exemple à partir d'une bobine alimentée par un signal sinusoïdal.

Lorsqu'on approche un élément sensible à excitation magnétique d'un pneumatique, le matériau ferromagnétique présent dans l'armature du pneumatique parcourt ce cycle d'hystérèse à la fréquence du signal d'alimentation de l'élément sensible. Ce faisant, ledit matériau subit un échauffement qualifié de perte hystérétique. Ces pertes augmentent avec la fréquence du signal d'alimentation du capteur et avec l'amplitude de l'excitation magnétique dans lequel baigne l'assemblage constituant l'armature de pneumatique. En outre, elles dépendent également de la surface intérieure au cycle d'hystérèse 210.

Ainsi, si l'amplitude du signal d'alimentation du capteur est stable, l'excitation magnétique dans lequel baigne l'armature de pneumatique peut varier à condition de faire varier la distance entre l'élément sensible et ladite armature. Le cas échéant, les pertes générées dans l'armature dépendent directement de la distance entre l'élément sensible et l'armature.

Or, l'armature du pneumatique est noyée dans une couche de gomme sous les éléments de sculpture amené à s'user au cours de la vie d'un pneumatique. Ainsi, si l'on appose l'élément sensible sur la face externe du pneumatique, la distance entre l'élément sensible et l'armature correspondra à la quantité de matériau restante. Il est donc possible d'évaluer le niveau d'usure du pneumatique en mesurant les pertes hystérétiques générées dans une armature de pneumatique.

La courbe 211 en traits discontinu montre la caractéristique magnétique d'une armature de pneumatique qui serait réalisée à partir d'un matériau métallique non ferromagnétique, par exemple, sous forme d'une tôle fine d'aluminium. Dans ce cas, il n'y a pas de cycle d'hystérèse puisqu'il s'agit d'un matériau amagnétique. Il n'y a donc pas de pertes hystérétiques et il n'est donc pas possible de mettre en oeuvre le procédé selon l'invention.

En revanche, il est possible dans ce cas d'observer des pertes par courant de Foucault, qui apparaissent lorsque le matériau répond à deux conditions :
- d'une part, le matériau est un bon conducteur électrique, ce qui est le cas des matériaux métalliques,
- et d'autre part, le matériau se présente sous une forme géométrique ayant des dimensions suffisantes dans au moins deux directions orthogonales

Ainsi, dans une configuration où l'armature du pneumatique comprend une tôle métallique, par exemple une tôle d'aluminium, noyée dans une nappe de gomme, le matériau répond aux deux conditions précédemment définies, puisque l'aluminium est un bon conducteur électrique, et que la tôle présente au moins une longueur et une largeur supérieure à un centimètre. Dans ce cas, des courants de Foucault sont effectivement créés.

En revanche, dans une configuration où l'armature du pneumatique est constituée d'un ensemble d'éléments de renforcement métalliques, notamment des câbles, noyés dans une nappe de caoutchouc, les éléments étant positionnés parallèlement les uns par rapport aux autres, il n'y aura pas de courants de Foucault qui s'établiront dans l'armature. En effet, une telle armature présente une caractéristique magnétique 210 telle que montrée sur la figure 3, et l'assemblage de gomme et de câbles ferromagnétiques ainsi constitué est un composite hystérétique du point de vue magnétique. Dans ce cas, les câbles ferromagnétiques sont conducteurs électriques mais ne comportent qu'une seule grande dimension, dans le sens de la longueur du câble puisque, les deux autres dimensions, orthogonales au sens de la longueur du câble, sont trop faibles, ne dépassant pas, par exemple, un pourcent de la dimension principale du câble dans le sens de sa longueur. Ainsi les conditions précitées pour l'apparition de courants de Foucault ne sont pas remplies, et par conséquent il n'y a pas de courants de Foucault qui s'établissent dans l'armature.

En outre, les courants de Foucault ne peuvent pas non plus s'établir d'un câble à l'autre puisque les câbles sont liés les uns aux autres par une liaison en gomme très résistive qui empêche la circulation du courant.

Par conséquent, un procédé selon l'invention est avantageusement mis en oeuvre dans le cas d'une armature de pneumatique, contenant au moins un type de matériau ferromagnétique hystérétique sous forme de câbles, et telle que la résistance mesurée entre deux points sur un tel assemblage montre que la résistivité globale du composite ainsi réalisé est d'au moins un megohms.mètres, et supérieure à dix megohms.mètres dans certains modes de réalisation.

Dans la suite de la description, on utilisera tour à tour les notions de conductivité ou de résistivité pour définir une telle armature métallique. On rappelle ici que la résistivité est la grandeur inverse de la conductivité.

Pour aboutir à cette valeur de résistivité, la résistance doit être mesurée entre deux points situés sur deux éléments distincts, ou entre deux points situés sur un même élément non métallique. Par « éléments distincts » on entend par exemple un élément de renforcement métallique et une masse de gomme, ou deux éléments de renforcement métalliques distincts appartenant à une même armature.

Dans cet exemple de mise en oeuvre, il n'y a pas de courants de Foucault qui s'établissent dans l'armature de pneumatique, et l'élément sensible utilisé dans un procédé selon la présente invention n'est pas un capteur à courant de Foucault.

Dans une réalisation préférentielle, l'étape d'approcher un élément sensible de la couche de matériau consiste à appliquer contre la face libre de la couche de matériau un boitier dans lequel l'élément sensible est installé. De manière avantageuse, le boitier comprend, outre l'élément sensible, un dispositif électronique de mesure.

Dans une réalisation préférentielle, l'élément sensible est un solénoïde, sous une des formes comprises dans le groupe comprenant : un circuit imprimé, un fil de cuivre bobiné avec ou sans support ferromagnétique.

Dans une réalisation préférentielle, le procédé comprend en outre les étapes suivantes :
- On alimente l'élément sensible par un signal électrique alternatif, et
- On fait varier la fréquence de ce signal d'alimentation.

De manière préférentielle, le signal d'alimentation de l'élément sensible est choisi avec une fréquence inférieure à une fréquence de coupure de l'élément sensible.

Dans une réalisation préférentielle, le procédé comprend l'étape préalable de détermination d'une fréquence d'excitation appropriée de la bobine.

Dans une réalisation préférentielle, l'élément sensible est formé de spires, et le procédé est tel que l'étape d'approcher l'élément sensible de la couche de matériau consiste à positionner l'élément sensible de telle sorte que le plan parallèle aux spires constituant la bobine soit parallèle à la surface de la face libre.

### BREVE DESCRIPTION DES FIGURES

D'autres objectifs et avantages de l'invention apparaîtront clairement dans la description qui va suivre de quelques modes de réalisation préférés mais non limitatifs, illustrés par les figures suivantes dans lesquelles :
- Les figures 1a et 1b détaillent un premier exemple d'élément sensible mis en oeuvre dans un procédé selon l'invention, et des courbes représentatives de la réponse fréquentielle d'un tel élément sensible.
- Les figures 2a et 2b, montre un second exemple d'élément sensible mis en oeuvre dans un procédé selon l'invention, et des courbes représentatives de la réponse fréquentielle d'un tel élément sensible.
- La figure 3, déjà décrite, montre la réponse magnétique d'un matériau constituant une armature adjacente de pneumatique, dans le cadre de la mise en oeuvre du procédé selon l'invention.

### DESCRIPTION DU MEILLEUR MODE DE REALISATION DE L'INVENTION

La figure la montre un premier exemple d'élément sensible mis en oeuvre dans un procédé selon l'invention. Dans cet exemple, l'élément sensible est une bobine 200, reliée à une électronique de mesure 100. De manière avantageuse, ces deux éléments sont installés dans un boitier, non représenté sur la figure, destiné à être positionné contre la couche de matériau à mesurer.

Ce boitier peut prendre la forme d'un élément portable, qu'un utilisateur approche à la main d'un pneumatique dont on souhaite mesurer l'épaisseur. Dans un autre exemple, le boitier peut prendre la forme d'un ralentisseur installé sur un sol de roulage, et sur lequel on fait passer un véhicule sur lequel est installé un pneumatique dont on souhaite mesurer l'usure. Dans une autre réalisation, le boitier peut être intégré dans le sol de roulage de façon à ne pas ralentir les véhicules dont on souhaite mesurer l'usure des pneumatiques.

Dans l'exemple de la figure la, la bobine 200 doit être alimentée par un signal électrique alternatif afin de réaliser la mesure d'épaisseur de couche de matériau caoutchouteux. Pour ce faire, il convient de fixer la fréquence d'excitation de ladite bobine à une valeur appropriée.

Une telle bobine 200 peut-être modélisée par l'association d'une self pure de valeur Ls et d'une résistance pure de valeur Rs. Cette résistance pure Rs est équivalente, pour une certaine gamme de fréquence du signal d'alimentation, à la somme de la résistance ohmique de la self et d'une composante résistive proportionnelle aux pertes générées par le champ magnétique émis par la bobine 200, dans le matériau constitutif de l'armature adjacente évoquée précédemment.

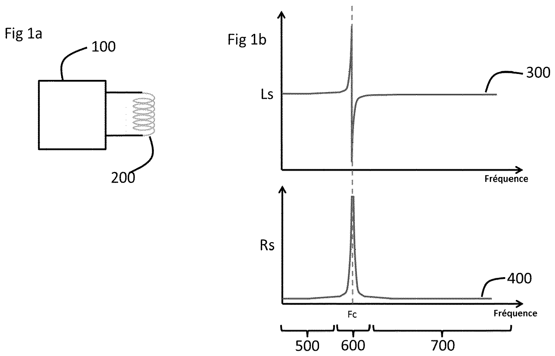

La figure 1b montre l'évolution des valeurs respectives de Ls (courbe 300) et de Rs (courbe 400), lorsqu'on fait varier la fréquence d'alimentation de la bobine 200, en l'absence d'armature adjacente. On voit ainsi apparaître trois zones de fonctionnement de la bobine 200.

La première zone 500 correspond à un mode de fonctionnement dans lequel la modélisation de la bobine 200 par une self positionnée en série avec une résistance est valide.

La seconde zone 600 correspond à une zone dans laquelle la self 200 se comporte comme un circuit bouchon, puisque la valeur de la résistance Rs augmente à tel point qu'il n'est plus possible d'alimenter ladite bobine 200. Le positionnement de la fréquence Fc, définissant cette zone dépend directement des caractéristiques de la bobine 200, telles que, de façon non exhaustive, son nombre de spires, sa résistance ohmique, le diamètre des fils conducteurs utilisés pour réaliser les spires ou encore la nature du matériau constituant les spires.

La troisième zone 700 est une zone de fonctionnement dans laquelle la bobine 200 n'est plus seulement assimilable à une self pure positionnée en série avec une résistance pure. Il faut dans ce cas, ajouter à ce modèle une capacité Cs. Selon les schémas de modélisation, cette capacité Cs peut-être positionnée en parallèle sur la self Ls pure ou en parallèle sur le couple formé par l'association de la self Ls et de la résistance Rs.

La zone 500 est la zone d'application préférée du procédé de mesure de l'épaisseur d'une couche de matériau caoutchouteux selon l'invention.

La figure 2a, montre la mise en oeuvre d'un procédé selon l'invention, pour mesurer l'épaisseur d'une couche de matériau 10, munie d'une armature adjacente 30 sur la face opposée à la face libre. Cette armature 30 a été réalisée au moyen de câbles d'acier assemblés parallèlement les uns aux autres par une matrice de matériau caoutchouteux très fortement résistive. L'armature ainsi constituée, est très peu électriquement conductrice, puisque les câbles ne sont pas en contact les uns avec les autres et puisqu'ils sont liés mécaniquement par l'intermédiaire d'une matrice résistive. En revanche, cette armature est une bonne conductrice de champ magnétique puisque les câbles sont ferromagnétiques.

La première étape d'un procédé selon l'invention consiste à positionner une bobine plate 20 contre la face libre de la couche de matériau 10. Cette bobine est ensuite alimentée par un signal d'alimentation dont la fréquence est inférieure à la fréquence de coupure Fc.de la bobine. On mesure alors la variation de la résistance vue aux bornes de la bobine.

Comme indiqué précédemment, la bobine 20 est équivalente à l'association d'une inductance pure Ls et d'une résistance Rs. Lorsqu'on fait varier la fréquence du signal d'alimentation de la bobine 20, pour une distance entre bobine 20 et armature 30 donnée, on constate une variation de la valeur de Rs.

Cette variation est la combinaison de la variation obtenue en absence d'armature pour une fréquence inférieure à Fc, comme exposé dans la figure 1b d'une part, et de la variation provoquée par la présence de l'armature 30 à proximité de la bobine 20 d'autre part.

La figure 2b montre l'évolution de la grandeur ΔRs correspondant à la part de variation de Rs, uniquement due à la présence de l'armature 30 à proximité de la bobine 20. Dans la figure 2b, cette variation est exposée en fonction de la fréquence du signal d'alimentation de la bobine 20.

Ainsi, la courbe 41 montre l'évolution de ΔRs obtenue lorsque l'épaisseur de matériau caoutchouteux 10 est de un millimètre.

La courbe 51 montre l'évolution de ΔRs obtenue lorsque l'épaisseur de matériau caoutchouteux 10 est de cinq millimètres.

La courbe 61 montre l'évolution de ΔRs obtenue lorsque l'épaisseur de matériau caoutchouteux 10 est de dix millimètres.

Enfin, la courbe 71 montre l'évolution de ΔRs obtenue lorsque l'épaisseur de matériau caoutchouteux 10 est de vingt millimètres.

Dans tous les cas, la fréquence du signal d'alimentation utilisé reste inférieure à la fréquence Fc définie dans l'exemple des figures 1a et 1b.

On constate que si on fixe la fréquence d'alimentation à un niveau F1 très inférieur à la fréquence Fc, il est difficile de séparer les variations des ΔRs obtenus à cette fréquence F1 pour une variation d'épaisseur de couche variant entre un et vingt millimètres.

En revanche, si on fixe la fréquence du signal d'alimentation à un niveau F2 plus élevé, on peut constater que la variation de ΔRs peut offrir une sensibilité bien meilleure lorsque l'épaisseur de couche de matériau caoutchouteux varie entre un et vingt millimètres.

Dans ce cas, il devient possible d'utiliser la variation de ΔRs pour mesurer l'épaisseur de matériau caoutchouteux.

Dans une variante du procédé selon l'invention, pour des valeurs élevées de fréquence d'alimentation de la bobine 20, il est également possible d'utiliser simultanément la variation de ΔLs et de ΔRs afin de réaliser une mesure d'épaisseur de couche.

En effet, dans ce cas, en absence de courants de Foucault, ΔLs augmente lorsque la distance entre la bobine 20 et l'armature 30 diminue. Cette variation va donc dans le même sens que la variation de ΔRs, puisque ΔRs augmente avec la diminution de la distance entre la bobine 20 et l'armature 30.

Avantageusement, on pourra utiliser la variation de ΔRs seule, ou combinée à la variation de ΔLs, Ce mode de réalisation sera notamment mais non exclusivement utilisé lorsque la fréquence d'alimentation de la bobine 20 dépasse dix pourcent de la fréquence Fc définie précédemment.

Alternativement on pourra utiliser directement la variation de Ls et de Rs, séparément ou de façon combinée, pour réaliser une mesure d'épaisseur de couche de matériau caoutchouteux. La distance ainsi mesurée correspond à la distance entre une face libre d'une couche de matériau caoutchouc et une armature métallique présente dans la couche. Ainsi, en approchant un élément sensible du sommet d'une sculpture, on peut déterminer l'usure des pneumatiques par comparaison entre une distance initiale entre le sommet de la sculpture et l'armature métallique, et une distance mesurée.

## Revendications

1. Procédé de mesure de l'épaisseur d'une couche de matériau (10) caoutchouteux, cette couche de matériau comportant une face libre en contact avec l'air et une face liée à une armature (30) adjacente constituée d'éléments isolés électriquement les uns des autres et contenant chacun au moins un matériau hystérétique de perméabilité magnétique supérieure à la perméabilité magnétique de l'air, le procédé comportant les étapes suivantes :
- Une étape au cours de laquelle on approche de la couche de matériau dont on souhaite mesurer l'épaisseur un élément sensible émettant un champ magnétique alternatif,
- Une étape au cours de laquelle on mesure des pertes hystérétiques dans l'armature adjacente, mesurées aux bornes de l'élément sensible, et
- Une étape au cours de laquelle on évalue l'épaisseur de la couche de matériau en fonction de ces pertes hystérétiques.

2. Procédé selon la revendication 1, dans lequel l'étape d'approcher un élément sensible de la couche de matériau consiste à appliquer contre la face libre de la couche de matériau un boîtier dans lequel l'élément sensible est installé.

3. Procédé selon la revendication 2, dans lequel le boitier comprend, outre l'élément sensible, un dispositif électronique de mesure.

4. Procédé selon l'une des revendications précédentes, dans lequel l'élément sensible est un solénoïde, sous une des formes comprises dans le groupe comprenant : un circuit imprimé, un fil de cuivre bobiné avec ou sans support ferromagnétique.

5. Procédé selon la revendication 1 comprenant les étapes suivantes :
- On alimente l'élément sensible par un signal électrique alternatif, et
- On fait varier la fréquence de ce signal d'alimentation.

6. Procédé selon la revendication 5, dans lequel le signal d'alimentation de l'élément sensible est choisi avec une fréquence inférieure à une fréquence de coupure de l'élément sensible.

7. Procédé selon la revendication 5, comprenant l'étape préalable de détermination d'une fréquence d'excitation appropriée de la bobine.

8. Procédé selon l'une des revendications précédentes, dans lequel l'élément sensible est formé de spires, le procédé étant tel que l'étape d'approcher l'élément sensible de la couche de matériau consiste à positionner l'élément sensible de telle sorte que le plan parallèle aux spires constituant la bobine soit parallèle à la surface de la face libre.

9. Procédé selon l'une des revendications précédentes, dans lequel la conductivité électrique de l'armature est telle que la résistivité mesurée entre deux points situés sur deux éléments distincts, ou entre deux points situés sur un même élément non métallique, est supérieure à un megohms.mètres

10. Procédé selon l'une des revendications précédentes, dans lequel la conductivité électrique de l'armature est telle que la résistivité mesurée entre deux points situés sur deux éléments distincts, ou entre deux points situés sur un même élément non métallique, est supérieure à dix megohms.mètres

## Patentansprüche

1. Verfahren zur Messung der dicke einer Schicht aus kautschukartigem Material (10), wobei diese Materialschicht eine freie Fläche in Kontakt mit der Luft und eine mit einer angrenzenden Bewehrung (30) verbundene Fläche umfasst, die von elektrisch voneinander isolierten Elementen gebildet ist, jeweils umfassend mindestens ein Hysteresematerial mit einer höheren magnetischen Durchlässigkeit als die magnetische Durchlässigkeit der Luft, wobei das Verfahren die folgenden Schritte umfasst:
- einen Schritt, während dessen an die Materialschicht, deren Dicke gemessen werden soll, ein sensibles Element angenähert wird, das ein magnetisches Wechselfeld entsendet,
- einen Schritt, während dessen Hystereseverluste in der angrenzenden Bewehrung gemessen werden, gemessen an den Klemmen des sensiblen Elements, und
- einen Schritt, während dessen die Dicke der Materialschicht in Abhängigkeit von diesen Hystereseverlusten bewertet wird.

2. Verfahren nach Anspruch 1, bei dem der Schritt der Annäherung eines sensiblen Elements an die Materialschicht darin besteht, an die freie Fläche der Materialschicht ein Gehäuse anzulegen, in dem das sensible Element installiert ist.

3. Verfahren nach Anspruch 2, bei dem das Gehäuse außer dem sensiblen Element eine elektronische Messeinrichtung umfasst.

4. Verfahren nach einem der vorhergehenden Ansprüche, bei dem das sensible Element ein Solenoid in einer der Formen aus der folgenden Gruppe ist: gedruckte Schaltung, gewickelter Kupferdraht mit oder ohne ferromagnetischem Träger.

5. Verfahren nach Anspruch 1, umfassend die folgenden Schritte:
- Versorgung des sensiblen Elements mit einem elektrischen Wechselsignal, und
- Variation der Frequenz dieses Versorgungssignals.

6. Verfahren nach Anspruch 5, bei dem das Versorgungssignal des sensiblen Elements mit einer Frequenz unter einer Unterbrechungsfrequenz des sensiblen Elements ausgewählt wird.

7. Verfahren nach Anspruch 5, umfassend den vorherigen Schritt der Bestimmung einer geeigneten Erregungsfrequenz der Spule.

8. Verfahren nach einem der vorhergehenden Ansprüche, bei dem das sensible Element von Windungen gebildet ist, wobei das Verfahren derart ist, dass der Schritt der Annäherung des sensiblen Elements an die Materialschicht darin besteht, das sensible Element derart zu positionieren, dass die Ebene parallel zu den Windungen, die die Spule bilden, parallel zur Oberfläche der freien Fläche ist.

9. Verfahren nach einem der vorhergehenden Ansprüche, bei dem die elektrische Leitfähigkeit der Bewehrung derart ist, dass die Widerstandsfähigkeit, die zwischen zwei Punkten, die sich auf zwei getrennten Elementen befinden, oder zwischen zwei Punkten, die sich auf einem selben nicht metallischen Element befinden, größer als ein Megohmmeter ist.

10. Verfahren nach einem der vorhergehenden Ansprüche, bei dem die elektrische Leitfähigkeit der Bewehrung derart ist, dass die Widerstandsfähigkeit, die zwischen zwei Punkten, die sich auf zwei getrennten Elementen befinden, oder zwischen zwei Punkten, die sich auf einem selben nicht metallischen Element befinden, größer als zehn Megohmmeter ist.

## Claims

1. Method for measuring the thickness of a layer (10) of rubber-like material, this layer of material comprising a free face in contact with the air and a face joined to an adjacent reinforcement (30) made of elements electrically insulated from one another, each of these elements containing at least one hysteresis material having a magnetic permeability greater than the magnetic permeability of air, the method comprising the following steps:
- A step in which a sensitive element emitting an alternating magnetic field is brought towards the layer of material whose thickness is to be measured,
- A step in which hysteresis losses in the adjacent reinforcement are measured, these losses being measured at the terminals of the sensitive element, and
- A step in which the thickness of the layer of material is evaluated on the basis of these hysteresis losses.

2. Method according to Claim 1, wherein the step of bringing a sensitive element towards the layer of material consists in applying to the free face of the layer of material a housing in which the sensitive element is installed.

3. Method according to Claim 2, wherein the housing comprises, in addition to the sensitive element, an electronic measuring device.

4. Method according to any of the preceding claims, wherein the sensitive element is a solenoid, in one of the forms included in the group comprising a printed circuit and a copper wire wound with or without a ferromagnetic support.

5. Method according to Claim 1, comprising the following steps:
- The sensitive element is supplied with an alternating electrical signal, and
- The frequency of this supply signal is made to vary.

6. Method according to Claim 5, wherein the supply signal of the sensitive element is selected with a frequency below a cut-off frequency of the sensitive element.

7. Method according to Claim 5, comprising the preliminary step of determining an appropriate excitation frequency of the coil.

8. Method according to any of the preceding claims, wherein the sensitive element is formed from turns, the method being such that the step of bringing the sensitive element towards the layer of material consists in positioning the sensitive element in such a way that the plane parallel to the turns forming the coil is parallel to the surface of the free face.

9. Method according to any of the preceding claims, wherein the electrical conductivity of the reinforcement is such that the resistivity measured between two points located on two separate elements, or between two points located on the same non-metallic element, is greater than one megohm metre.

10. Method according to any of the preceding claims, wherein the electrical conductivity of the reinforcement is such that the resistivity measured between two points located on two separate elements, or between two points located on the same non-metallic element, is greater than ten megohm metre.
